# EUROPEAN PATENT APPLICATION

(11) **EP 4 040 352 A1**
(43) Date of publication of application: **10.08.2022**
(21) Application number: 22155960.2
(22) Date of filing: 09.02.2022
(51) Int. Cl.: G06Q 10/00, G06Q 10/08

(54) **A METHOD FOR IMPROVING THE OPERATIONAL AVAILABILITY OF AN AIRCRAFT FLEET**

(30) Priority: 09.02.2021 US 202117171847
(71) Applicant: Simmonds Precision Products, Inc., Vergennes, VT 05491 (US)
(72) Inventor: DEWIND, Eric, Vermont, 05477 (US); SOPKO, Richard Joseph, Vermont, 05452 (US); CARNEY, Eric, Vermont, 05482 (US)
(74) Representative: Dehns

(57) **Abstract**

A method including identifying a plurality of maintenance schedules for a plurality of aircraft of a fleet of aircrafts each of which satisfy a minimum maintenance free operating period;, monitoring and measuring a health of each of the aircrafts, utilizing the measured heath of the aircrafts within a degradation model in order to produce a plurality possible maintenance events for each of the aircrafts, each of the possible maintenance events associated with a different maintenance time, identifying at least one maintenance event for each aircraft in the fleet of aircraft using the set of possible maintenance events found for each aircraft from the plurality of maintenance schedules resulting in number of aircraft down for maintenance below a predetermined threshold, and executing the at least one maintenance event based on the at least one identified maintenance event.

## Description

### Background

### Technological Field

The present disclosure relates to methods for improving operation availability for a vehicle, specifically improving the fleet operational availability of an aircraft fleet.

### Description of Related Art

Aircraft component failures and un-scheduled maintenance are disruptive to planning missions and limit the overall availability of the aircraft fleet. A Maintenance Free Operating Period (MFOP)is a concept devised to guarantee with a high probability of confidence that an aircraft will not require maintenance during a defined period of time. This allows aircraft to be deployed to remote areas that may not have the facilities, components, and personnel available to address maintenance needs. It also allows aircraft availability to be projected with a higher degree of confidence.

The aircraft fleet operational availability is the percentage of aircraft in the fleet which are capable of performing a mission at a given time. A fleet's operational availability is to remain above the target fleet operational availability threshold at all times.

Although a maximum fleet operational availability is desired it cannot come at an expense of excessive aircraft downtime or a reduced MFOP. Maintaining or replacing a large set of systems every time an aircraft requires maintenance will increase MFOP but the time the aircraft is unavailable and the cost of excessive preventative maintenance will likely be unacceptable. Reducing the MFOP will shorten the maintenance downtime and allow for flexible maintenance schedule but will not satisfy the aircraft's MFOP requirement.

Conventional methods of for handling aircraft fleet scheduling have generally been considered satisfactory for their intended purpose. However, there is still a need in the art for improved aircraft fleet scheduling methodologies. The present disclosure provides a solution for this need.

### Summary of the Invention

A method is disclosed including identifying a plurality of maintenance schedules for a plurality of aircraft of a fleet of aircrafts each of which satisfy a target fleet operational availability, monitoring and measuring a health of each of the aircrafts, utilizing the measured heath of the aircrafts within a degradation model in order to produce a plurality of possible maintenance events for each of the aircrafts, each maintenance event being associated with a different maintenance time, identifying at least one maintenance event for each aircraft in the fleet of aircraft using the set of possible maintenance events found for each aircraft from the plurality of maintenance schedules resulting in number of aircraft down for maintenance below a predetermined threshold, executing the at least one maintenance event based on the at least one identified maintenance event.

Each aircraft can include a plurality of systems. The degradation model can produce a plurality of simulation outcomes. The degradation model can be a Monte Carlo simulation using loading coefficients picked from a distribution of plausible missions. The loading coefficients can be selected based on historical data or on predicted future conditions.

The degradation model can produce a set of predicted load values for at least one physical component of each aircraft, for a system of an aircraft, or for the aircraft as a whole, wherein each predicted load value is taken from the set of predicted load values corresponding uniquely to one of an ordered sequence of index values. The degradation model can produce a set of predicted wear indicator values corresponding to the at least one component or system, each predicted wear indicator value of the set of predicted wear indicator values corresponding uniquely to one of the ordered sequence of index values based on one of the predicted load values from the set of predicted load values that corresponds to a sequentially previous index value and one of the predicted wear indicator values from the set of predicted wear indicator values that corresponds to the sequentially previous index value. A predicted amount of remaining useful life can be determined of the at least one physical component based on the set of predicted wear indicator values.

The method can further include identifying all maintenance which cause the target fleet operational availability to be violated. The method can include selecting alternative maintenance schedules that do not result in a violation of the target fleet operational availability.
These and other features of the systems and methods of the subject disclosure will become more readily apparent to those skilled in the art from the following detailed description of the preferred embodiments taken in conjunction with the drawings.

### Brief Description of the Drawings

So that those skilled in the art to which the subject disclosure appertains will readily understand how to make and use the devices and methods of the subject disclosure without undue experimentation, embodiments thereof will be described in detail herein below with reference to certain figures, wherein:

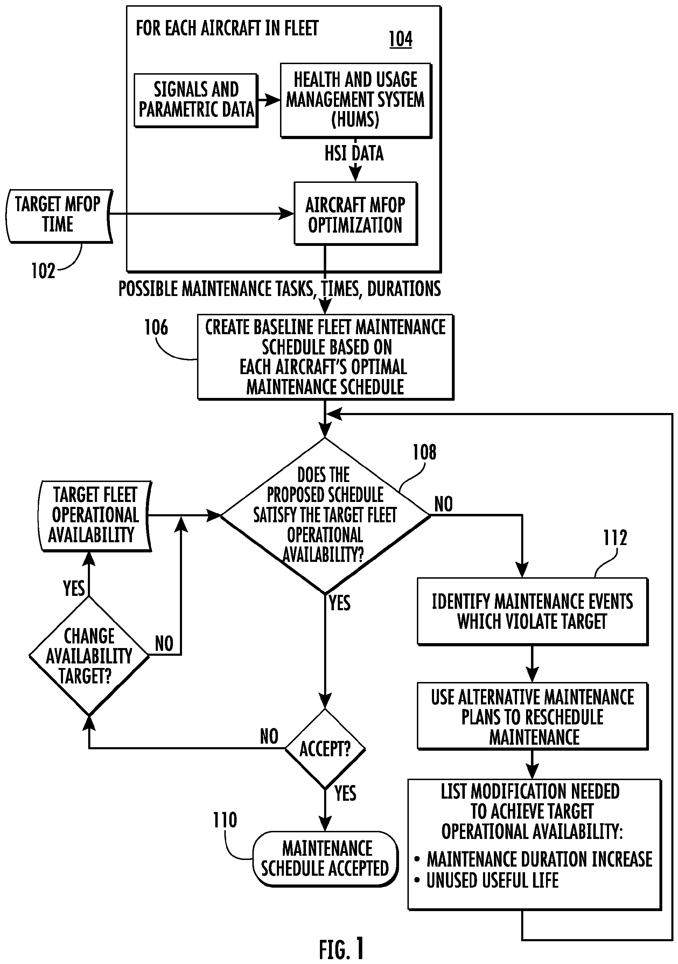

FIG. 1 is a block diagram of a method for achieving the maintenance free operation period according an embodiment of the disclosure.

### Detailed Description

For purposes of explanation and illustration, and not limitation, a partial view of an exemplary embodiment of a method in accordance with the disclosure is shown in FIG. 1 and is designated generally by reference character 100. The method described herein can be used to forecast when a system is likely to need maintenance, and providing suggestions for maintaining other systems in order to achieve a target operational availability for an aircraft fleet.

Fig. 1 shows steps of a method 100 including identifying a plurality of maintenance schedules for a plurality of aircraft of a fleet of aircrafts, wherein each aircraft includes a plurality of systems. each of which satisfy a minimum maintenance free operating period 102, monitoring and measuring a health of each of the aircrafts using a health and usage management system of each aircraft (HUMS) 104, utilizing the measured heath of the aircrafts within a degradation model in order to produce a plurality possible maintenance events for each of the aircrafts, each maintenance event being associated with a different maintenance time 106, identifying at least one maintenance event for each aircraft in the fleet of aircraft using the set of possible maintenance events found for each aircraft from the plurality of maintenance schedules resulting in number of aircraft down for maintenance below a predetermined threshold, and executing 110 the at least one maintenance event based on the at least one identified maintenance event.

The degradation model produces a plurality of simulation outcomes using a Monte Carlo simulation. The Monte Carlo simulation can use loading coefficients picked from a distribution of plausible missions. The loading coefficients can be selected based on historical data. The loading coefficients can be selected based on predicted future conditions.

The degradation model can produce a set of predicted load values for at least one physical component of the system, each predicted load value from the set of predicted load values corresponding uniquely to one of an ordered sequence of index values, a set of predicted wear indicator values corresponding to the at least one physical system component, each predicted wear indicator value of the set of predicted wear indicator values corresponding uniquely to one of the ordered sequence of index values based on one of the predicted load values from the set of predicted load values that corresponds to a sequentially previous index value and one of the predicted wear indicator values from the set of predicted wear indicator values that corresponds to the sequentially previous index value. The predicted amount of remaining useful life can be determined of the at least one physical component based on the set of predicted wear indicator values.

The method can include identifying 112 allmaintenance events which cause the target fleet operational availability to be violated. The method can include identifying alternative maintenance events that have different maintenances time than the violating maintenance events from the set of possible maintenance events such that the target fleet operational availability is satisfied.

While the apparatus and methods of the subject disclosure have been shown and described with reference to preferred embodiments, those skilled in the art will readily appreciate that changes and/or modifications may be made thereto without departing from the scope of the subject disclosure.

## Claims

1. A method comprising:
identifying a plurality of maintenance schedules for a plurality of aircraft of a fleet of aircrafts each of which satisfy a target;
monitoring and measuring a health of each of the aircrafts;
utilizing the measured health of the aircrafts within a degradation model in order to produce a plurality of possible maintenance events for each of the aircrafts, each maintenance event being associated with a different maintenance time;
identifying at least one maintenance event for each aircraft in the fleet of aircraft using the set of possible maintenance events found for each aircraft from the plurality of maintenance schedules resulting in number of aircraft down for maintenance below a predetermined threshold; and
executing the at least one maintenance event based on the at least one identified maintenance event.

2. The method of claim 1, wherein each aircraft includes a plurality of systems.

3. The method of claim 1 or 2, wherein the degradation model produces a plurality of simulation outcomes.

4. The method of claim 1, 2 or 3, wherein the degradation model is a Monte Carlo simulation.

5. The method of claim 4, wherein the Monte Carlo simulation uses loading coefficients picked from a distribution of plausible missions.

6. The method of claim 5, wherein the loading coefficients are selected based on historical data.

7. The method of claim 5 or 6, wherein the loading coefficients are selected based on predicted future conditions.

8. The method of any preceding claim, wherein the degradation model produces:
a set of predicted load values for at least one physical component of each aircraft, each predicted load value from the set of predicted load values corresponding uniquely to one of an ordered sequence of index values;
a set of predicted wear indicator values corresponding to the at least one physical system component, each predicted wear indicator value of the set of predicted wear indicator values corresponding uniquely to one of the ordered sequence of index values based on one of the predicted load values from the set of predicted load values that corresponds to a sequentially previous index value and one of the predicted wear indicator values from the set of predicted wear indicator values that corresponds to the sequentially previous index value.

9. The method of claim 8, wherein a predicted amount of remaining useful life is determined of the at least one physical component based on the set of predicted wear indicator values.

10. The method of any preceding claim, further comprising identifying multiple maintenance events which causes the target fleet operational availability to be violated.

11. The method of any preceding claim, further comprising identifying alternative maintenance events which does not cause the target fleet operational availability to be violated.

12. The method of claim 11, further comprising performing at least one of the identified events.

13. The method of claim 12, further comprising performing a plurality of the identified events.

14. The method of any preceding claim, wherein the aircraft is part of an aircraft fleet.

15. The method of any preceding claim, wherein the aircraft is part of vertical lift aircraft fleet.
